# FASCICULE DE BREVET EUROPEEN

(11) **EP 3 635 153 B1**
(45) Date de publication et mention de la délivrance du brevet: **16.03.2022**
(21) Numéro de dépôt: 18736996.2
(22) Date de dépôt: 08.06.2018
(51) Int. Cl.: C23C 16/27, C23C 16/52, C30B 25/16, C30B 29/04

(54) **PROCÉDÉ ET DISPOSITIF POUR LA SURVEILLANCE D'UN DÉPÔT ASSISTÉ PAR PLASMA MICROONDE**
VERFAHREN UND VORRICHTUNG ZUR ÜBERWACHUNG EINER MIKROWELLENPLASMAUNTERSTÜTZTEN ABSCHEIDUNG
METHOD AND DEVICE FOR MONITORING A MICROWAVE PLASMA ASSISTED DEPOSITION

(30) Priorité: 09.06.2017 FR 1755200
(43) Date de publication de la demande: 15.04.2020
(73) Titulaire: Diam Concept, 75116 Paris (FR)
(72) Inventeur: DUIGOU, Olivier, 91300 Massy (FR); BIEBER, Thomas, 92210 Saint Cloud (FR); GICQUEL, Alix, 14360 Trouville sur mer (FR)
(74) Mandataire: A.P.I. Conseil
(86) Numéro de dépôt international: PCT/FR2018/051337
(87) Numéro de publication internationale: WO 2018/224792

(56) Documents cités:
- WO-A1-2014/035344
- JP-A- H0 597 581
- US-A1- 2015 110 949
- YUZO SHIGESATO ET AL: "EMISSION SPECTROSCOPY DURING DIRECT-CURRENT-BIASED, MICROWAVE-PLASMA CHEMICAL VAPOR DEPOSITION OF DIAMOND", APPLIED PHYSICS LETTERS, A I P PUBLISHING LLC, US, vol. 63, no. 3, 19 juillet 1993 (1993-07-19), pages 314-316, XP000382582, ISSN: 0003-6951, DOI: 10.1063/1.110055

## Description

L'invention concerne le domaine de la synthèse de diamant par dépôt assisté par plasma microonde. L'invention porte sur un procédé pour la surveillance d'un dépôt assisté par plasma microonde. L'invention porte également sur un dispositif de surveillance d'un dépôt assisté par plasma microonde et sur un système de contrôle-commande d'un réacteur de dépôt, associé à un tel dispositif.

### [Art antérieur]

Grâce à ses propriétés mécaniques, optiques, thermiques, électroniques et chimiques, le diamant synthétique est de plus en plus utilisé dans l'industrie. Ainsi, il est retrouvé comme constituant essentiel de nombreux produits tels que les fenêtres optiques, les outils de coupe, les détecteurs de rayonnement, les électrodes, mais également en électronique active et passive, comme drain thermique et il est très prometteur pour des applications en électronique de puissance.

Cette multiplication des applications entraîne une demande toujours plus importante ainsi qu'une recherche de réduction des coûts de production et de standardisation des productions.

L'Homme du métier connaît l'influence et l'interdépendance de nombreuses variables pour ajuster les conditions de croissance aux objectifs poursuivis. Pendant les phases de dépôt et de croissance des couches de diamant, il est connu de l'Homme du métier que des variables et paramètres tels que la pression, la puissance, la température du ou des substrats, la concentration et la composition des gaz injectés, leur distribution au sein du réacteur, la propagation électromagnétique, la position et la dimension du ou des substrats, leur distance par rapport au plasma produisent des effets sur la croissance de couches de diamant.

Alors qu'il n'est possible de vérifier l'état des couches de diamants produites qu'une fois l'étape de synthèse finalisée, il a été mis en place différents outils pour surveiller le processus de dépôt et si nécessaire mettre en œuvre des actions correctives.

Par exemple, les mesures de la densité d'hydrogène atomique (H) et de la température du gaz (*T_{g}*) dans un plasma de dépôt de diamant peuvent conduire à une bonne connaissance de l'efficacité du réacteur. La mesure de température de gaz peut être obtenue à partir de mesures de température rotationnelle de l'hydrogène moléculaire, et de mesures de température rotationnelle de molécules C₂, CH, BH... à l'état excité par OES (Optical Emission Spectroscopy) ou encore, dans l'état fondamental, à partir du radical CH ou C₂ par DFWM (Degenerate Four-Wave Mixing) ou de l'atome d'hydrogène (TALIF). Des mesures de température du gaz faites à partir de l'émission des bandes Swan de C₂ ont par exemple montré un très bon accord avec les mesures effectuées par TALIF (Two photon Allowed transition Laser Induced Fluorescence) sur l'hydrogène atomique (Derkaoui et al., J. Appl. Phys. 115, 233301, 2014).

Pour les mesures de densité de H dans un plasma, les techniques d'actinométrie (OES - Optical Emission Spectroscopy), THG (Third-Harmonic Génération), TALIF, CRDS (Cavity Ring Down Spectroscopy) sont bien adaptées.

En outre, un suivi des intensités d'émission par OES de certaines transitions électroniques des radicaux CH, CH₂, C₂, CN, NH, Ar ainsi que de leur rapport constitue un moyen intéressant pour le contrôle et la commande d'un réacteur de dépôt de diamant (Yuzo Shigesato et al. Applied physics letters 63 (3), 314-316,1993).

Pour la mesure de la densité d'espèces carbonées telles que CH, CH₃, CH₄, C₂, C₂H₂, C₂H₄, C₂H₆ plusieurs méthodes ont été mises au point : la BAS (Lombardi et al. Plasma Sources Science and Technology, 13:3, 375 ; 2004), l'absorption dans l'ultraviolet (UV) (Cappelli et al., Applied physics letters 70 (8), 1052-1054,1997 ; Cappelli et al., Plasma Chemistry and Plasma Processing, Vol. 20, No. 1, 2000) et l'infrarouge (IR) en utilisant les diodes laser (TDLAS : Tunable Diode Laser Absorption Spectroscopy) (Rôpcke, et al. Plasma Chemistry and Plasma Processing, 22:137 ; 2002), (Butler, High Temperature Science, 27, 183-197 ; 1989) ou les QCLs (Quantum cascade lasers) (Ma, et al. Journal of Applied Physics, 106:3, 033305-033315 ; 2009), la LIF (Kaminski, et al. Applied Physics B:Lasers and Optics, 61:6, 585-592 ; 1995), la DFWM (Owano, et al. Diamond and Related Materials, 2:5-7, 661-666 ; 1993), la CRDS (Hay, et al. Journal of Materials Research, 5:11 ; 1990] et la MS (Mass Spectrometry) (Hsu, et al. Journal of Applied Physics, 72:7, 3102-3109 ; 1992) .

Néanmoins, ces méthodes ne s'intéressent pas directement au comportement de la couche de diamant en croissance alors qu'il impactera majoritairement la qualité du produit final. En effet, il a été montré que la température du ou des substrats ou du support de substrat est un paramètre de grande importance dans la formation de ces couches de diamant.

Dans cette optique, la température du substrat ou des couches de diamant peut être généralement suivie par pyrométrie infrarouge (IR). Le pyromètre est un dispositif optique qui détecte l'émission infrarouge de l'élément observé (par exemple dans la gamme de longueur d'onde de l'ordre de 2 µm) et en déduit la température. Un système à double longueur d'onde est généralement utilisé. Celui-ci permet d'isoler la température maximale mesurée dans la zone ciblée (qui correspond au substrat, plus chaud que le support) et de limiter les erreurs dues au plasma et à la fenêtre optique. Néanmoins, l'objet observé doit se trouver dans le plan focal du pyromètre, et la zone ciblée correspond à un point précis de l'ordre d'un centimètre de diamètre. Ainsi, si une nouvelle zone doit être ciblée alors il est nécessaire de déplacer le pyromètre. En outre, dans le cadre de l'observation de substrats monocristallins durant un procédé plasma, le plasma, la fenêtre optique à travers laquelle la mesure est réalisée ainsi que la dimension du substrat s'il est plus petit que la zone de mesure, peuvent induire des erreurs dans la détermination de la température du substrat. De plus, la mesure de la température par pyrométrie peut être perturbée en présence d'un plasma très énergétique ou de taille importante.

Il est également connu du document JP H05 97581, une méthode pour la synthèse de diamant utilisant une croissance en phase vapeur et un suivi de la croissance reposant sur une excitation des couches en croissance par un faisceau laser et l'analyse d'un rayonnement lumineux émis par un spectroscope. Néanmoins cette méthode ne permet ni de suivre de façon continu l'ensemble des paramètres ni l'ensemble des couches de diamant en formation.

Une autre méthode pour produire des diamants en phase vapeur est décrite dans le document WO 2014/035344, utilisant la présence de moyen de haute-fidélité pour capturer l'image de la croissance en surface des diamants. Toutefois, cette méthode permet uniquement de suivre la croissance en surface des diamants sans pouvoir mettre en évidence un suivi continu de l'ensemble des variations dues aux changements dans les conditions locales de croissance (e.g. température de surface, plasma) des couches de diamant en formation.

Ainsi, il existe un besoin de nouveaux moyens et procédés capables de répondre aux problèmes engendrés par les réacteurs commerciaux disponibles actuellement et notamment capables de surveiller en continu l'ensemble des couches de diamant en formation.

### [Problème technique]

L'invention a donc pour but de remédier aux inconvénients de l'art antérieur. En particulier, l'invention a pour but de proposer un procédé de surveillance d'un dépôt assisté par plasma microonde pour la fabrication de diamant, ledit procédé permettant de suivre rapidement et en temps réel l'influence des valeurs de paramètres de dépôt sur la croissance de couche de diamant et peut également permettre de déterminer de nouveaux paramètres permettant d'améliorer la croissance des couches de diamant, puis de les mettre en application.

### [Brève description de l'invention]

A cet effet, l'invention porte sur un procédé de surveillance des conditions de croissance d'un dépôt assisté par plasma microonde pour la fabrication de diamant, comme défini par la revendication 1, ledit procédé étant mis en œuvre par un dispositif de surveillance comprenant au moins un moyen de capture d'image numérique, un module de traitement d'image numérique, et un module de traitement de données et ledit procédé comportant les étapes :
- de capture d'une image numérique en couleur d'au moins une couche de diamant en croissance, à l'aide du moyen de capture d'images numériques,
- d'extraction de valeurs de caractéristiques de couleur d'au moins une zone de l'image numérique capturée, par le module de traitement d'image numérique, et
- d'analyse, par le module de traitement de données, des valeurs de caractéristiques de couleur extraites pour détecter une déviation des conditions de croissance lors du dépôt assisté par plasma microonde.

En effet, il a été montré par les inventeurs que le suivi de la couleur de la surface des couches de diamants en croissance, de la tranche du monocristal en croissance ou de la surface ou de la tranche du support de croissance permet de suivre le procédé de dépôt de façon précise et rapide. De plus, outre la surveillance et la détection d'une déviation, ce suivi pourrait être utilisé pour déterminer des paramètres de dépôt améliorés. Ainsi, les inventeurs proposent pour la première fois un procédé fondé sur le suivi, de préférence en continue de la couleur d'une couche de diamant en croissance au sein de la cavité résonante d'un réacteur de dépôt pour surveiller la croissance. Un tel procédé peut permettre notamment d'identifier un problème de synthèse lorsqu'il y a par exemple une différence de valeurs de caractéristiques de couleurs ou encore une déviation par rapport aux valeurs de caractéristiques de couleurs habituellement observées dans ces conditions. Cela est particulièrement avantageux lors de son application dans des conditions où la ou les couches de diamant sont positionnées sur un support de croissance mobile ou bien lorsqu'il y a, au sein du réacteur de dépôt, de nombreux monocristaux de diamant ou un wafer de diamant polycristallin en croissance.

Selon d'autres caractéristiques optionnelles et avantageuses du procédé, il comprend une étape de détermination de nouvelles valeurs de paramètres de dépôt assisté par plasma microonde et une étape de commande incluant la transmission des nouvelles valeurs de paramètres de dépôt, déterminées par le module de traitement de données, à un module de commande et la modification, par le module de commande, des valeurs de paramètres de dépôt assisté par plasma. Cela permet de faire évoluer les paramètres de croissance. La mise en œuvre de ce procédé permet une industrialisation du suivi et de la gestion de la croissance des couches de diamant.

L'invention porte en outre sur un **dispositif de surveillance des conditions de croissance d'un dépôt assisté par plasma microonde** pour la fabrication de diamant, comme défini par la revendication 11, apte à mettre en œuvre le procédé de surveillance selon l'invention, ledit dispositif comportant :
- un moyen de capture d'image numérique, apte à capturer une image numérique en couleur d'au moins un diamant en croissance,
- un module de traitement d'image numérique, apte à extraire des valeurs de caractéristiques de couleur d'au moins une zone de l'image numérique capturée, et
- un module de traitement de données, apte à détecter, à partir des valeurs de caractéristiques de couleur extraites, une déviation des
conditions de croissance lors du dépôt assisté par plasma microonde. Avantageusement ce système est complété par un suivi spectroscopique du plasma et de la mesure de températures des couches de diamant par pyrométrie.

En outre, le module de traitement de données peut être apte à déterminer de nouvelles valeurs de paramètres de dépôt assisté par plasma microonde à partir des valeurs de caractéristiques de couleur extraites.

L'invention porte également sur un **système de contrôle-commande de dépôt** assisté par plasma microonde pour la fabrication de diamant, comme défini par la revendication 12, comportant un réacteur de dépôt assisté par plasma microonde ainsi qu'un dispositif de surveillance selon l'invention et un module de commande, configuré pour recevoir les nouvelles valeurs de paramètres de dépôt générées par le module de traitement de données du dispositif de surveillance et apte à modifier les valeurs de paramètres de dépôt du réacteur en fonction desdites nouvelles valeurs de paramètre de dépôt. Ce système peut avantageusement comprendre en outre un pyromètre à deux longueurs d'onde et un dispositif de spectroscopie d'émission.

D'autres avantages et caractéristiques de l'invention apparaitront à la lecture de la description suivante donnée à titre d'exemple illustratif et non limitatif, en référence aux Figures annexées qui représentent :
- Figure 1, une vue schématique d'un procédé de surveillance d'une croissance d'un monocristal de diamant assisté par plasma microonde selon l'invention. Les étapes encadrées par des pointillés sont facultatives.
- Figure 2, une vue schématique en coupe d'un réacteur de dépôt assisté par plasma microonde associé à un dispositif de surveillance selon l'invention.
- Figure 3, une représentation de l'évolution de la valeur RVB (Rouge Vert Bleu ou RGB en anglais) de pixels suivis en fonction du temps de croissance pour différentes zones d'un monocristal de diamant en croissance : la surface du diamant (carrés), le centre (triangles) et le bas (cercles).

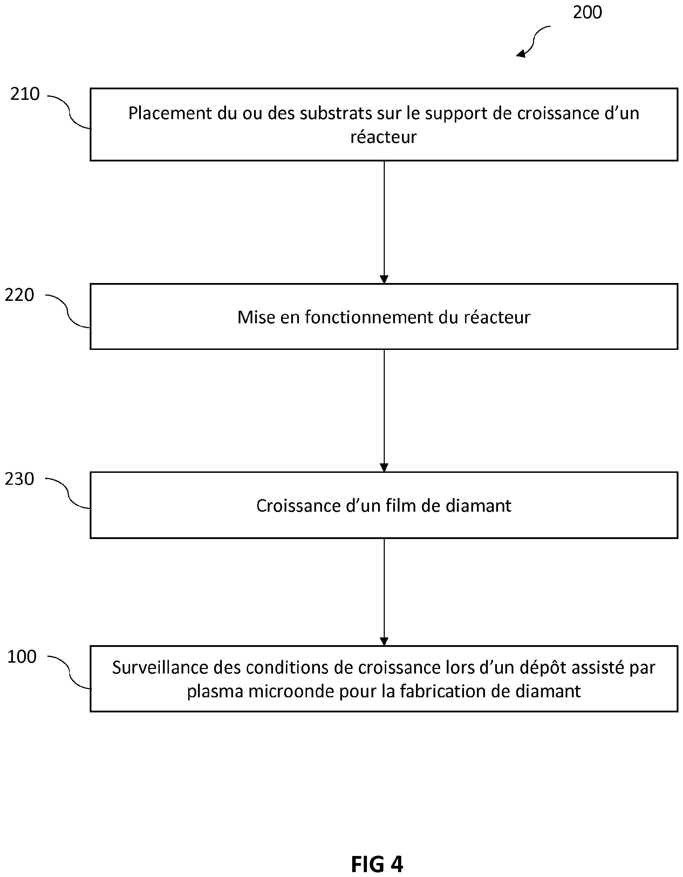

- La figure 4, une vue schématique d'un procédé de synthèse de diamant par dépôt assisté par plasma microonde selon l'invention.

### [Description de l'invention]

Dans la suite de la description, on entend par « **sensiblement identique** » ou **« sensiblement égale** », une valeur variant de moins de 30 % par rapport à la valeur comparée, de préférence de moins de 20 %, de façon encore plus préférée de moins de 10 %.

Le terme « **croissance** » au sens de l'invention correspond à l'étape ou aux étapes de dépôt de carbone sous forme sp3 de diamant cristallin (polycristallin ou monocristallin) contribuant à la production d'une couche de diamant polycristallin, d'un monocristal de diamant ou encore de diamant nanocristallin ou ultra-nanocristallin. Les conditions de croissance et paramètres de dépôt représentent un ensemble de valeurs des variables : pression, puissance microonde injectée, débit total des gaz, débit du précurseur carboné, débit d'impuretés et de dopant, composition du gaz de résistance et leur débit, températures de la couche ou des couches en croissance pour un réacteur donné.

Le terme « **diamant** » au sens de l'invention correspond à une ou plusieurs couches de diamant polycristallin ou monocristallin plus au moins épaisses, résultant du dépôt de carbone sous forme sp3 de diamant cristallin (polycristallin ou monocristallin). Notons que le réacteur peut aussi être utilisé pour la croissance de diamant nanocristallin ou ultra-nanocristallin, moyennant une adaptation des conditions de croissance (température de la surface en croissance, composition du gaz, conditions de pression et de puissance, ...).

L'expression **« film de diamant** » ou « **couche de diamant** » au sens de l'invention correspond à une couche (ou un film) de diamant polycristallin, nanocristallin ou ultra-nanocristallin formée après nucléation sur une surface de matériau non diamant (métal, silicium, carbure de silicium, autres) mais également une surface de diamant monocristallin ou polycristallin. Il correspond également à l'obtention de diamant monocristallin par épaississement en hauteur et/ou en largeur d'un monocristal de diamant souche (ou substrat) provenant d'un monocristal de diamant naturel ou produit par procédé haute pression- haute température (HPHT) ou produit par CVD (chemical vapor deposition assisté par plasma ou par filament chaud, autre).

Le terme « **plasma** » au sens de l'invention correspond à la production, à partir d'une décharge électrique dans un gaz composé d'un mélange, d'un milieu globalement neutre électriquement mais contenant des ions et des électrons ainsi que des fragments d'espèces gazeuses dissociées ainsi que des molécules stables.

Le terme « **substrat** » au sens de l'invention correspond aux éléments sur lesquels les couches ou films de diamant croissent. Il s'agit, pour les films de diamant polycristallin nanocristallin ou ultra-nanocristallin, de matériaux non diamant (métal, silicium, carbure de silicium, autres) ou diamant dans le cas de croissance multi-couches (multi-dopage ou multi-propriétés ou multi-couleurs, etc.) et pour les films monocristallins de monocristaux de diamant naturel ou produits par procédé haute pression- haute température (HPHT) ou encore produits par processus CVD (chemical vapor deposition assisté par plasma ou par filament chaud, autre).

L'expression **« gaz de résistance thermique»** au sens de l'invention correspond à un mélange gazeux composé de gaz purs ayant des conductivités thermiques très différentes permettant en changeant la composition de changer la conductivité thermique du mélange.

L'expression « **cavité résonante** » au sens de l'invention correspond à une sous-partie du volume formé par l'enceinte, cette sous-partie comportant notamment le lieu de formation du plasma et l'emplacement du ou des substrats. C'est dans la cavité résonante que la croissance est réalisée. La cavité résonante dépend d'un ensemble composé d'un générateur microonde, de l'applicateur et du système d'accord d'impédance, de la source de gaz où s'effectue le dépôt d'énergie microonde au sein de l'enceinte.

L'expression « **surface de croissance** » au sens de l'invention correspond à la surface située dans la cavité résonante et destinée à la croissance de diamant monocristallin ou de surfaces non diamant (croissance de diamant polycristallin).

L'expression « **support de croissance** » au sens de l'invention correspond à un élément, de préférence métallique, par exemple en molybdène, destiné à recevoir le ou les substrats.

Dans la suite de la description, les mêmes références sont utilisées pour désigner les mêmes éléments.

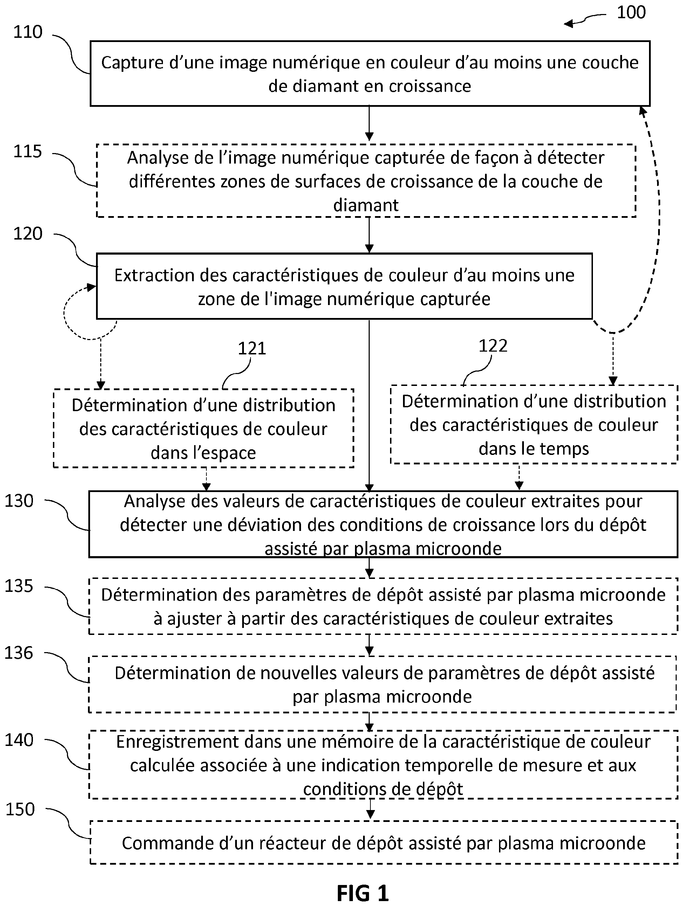

La Figure 1 schématise un procédé de surveillance des conditions de croissance d'un dépôt assisté par plasma microonde pour la fabrication de diamant selon l'invention.

En effet, **selon un premier aspect,** l'invention porte sur procédé 100 de surveillance des conditions de croissance lors d'un dépôt assisté par plasma microonde pour la fabrication de diamant, ledit procédé comportant les étapes :
- de capture 110 d'une image numérique en couleur d'au moins une couche de diamant en croissance (par exemple un monocristal de diamant), à l'aide d'un moyen 11 de capture d'images numériques,
- d'extraction 120 des caractéristiques de couleur d'au moins une zone de l'image numérique capturée, par un module 12 de traitement d'image numérique, et
- d'analyse 130, par un module 13 de traitement de données, des valeurs de caractéristiques de couleur extraites pour détecter une déviation des conditions de croissance lors du dépôt assisté par plasma microonde.

Ce procédé est de préférence mis en œuvre par un dispositif 10 de surveillance comprenant au moins un moyen 11 de capture d'image numérique, un module 12 de traitement d'image numérique, et un module 13 de traitement de données.

**L'étape de capture 110** d'une image numérique en couleur est réalisée à partir d'un moyen 11 de capture d'images numériques. Ce moyen 11 de capture d'images numériques peut par exemple être une caméra numérique, un appareil photo numérique ou un capteur CCD (Charge Coupled Device). Ce dispositif peut être muni d'éléments optiques complémentaires tels que des objectifs, filtres neutres, filtres interférentiels, ou des filtres spectraux. En outre, la caméra est de préférence préalablement calibrée par exemple par le niveau de gain, de saturation, en incluant l'effet des éventuels filtres. Cette calibration peut notamment être fonction de la fréquence de l'onde excitatrice et de l'épaisseur de plasma traversé ainsi que des caractéristiques de plasma (pression, puissance, composition des gaz...).

L'étape de capture 110 se fait généralement au travers d'une fenêtre d'observation. De façon préférée, dans le cadre du procédé, la teinte de la fenêtre d'observation est prise en compte par une mesure des propriétés optiques d'absorption en fonction du temps. En effet, au fil des expériences de dépôt, la teinte de la fenêtre d'observation peut évoluer. Cette prise en compte peut être réalisée durant l'étape d'extraction 120.

De façon préférée, l'étape de capture peut être suivie d'une **étape 115 d'analyse** de l'image numérique capturée de façon à détecter différentes zones de surfaces de croissance de la couche de diamant. Par exemple il est possible de détecter différentes zones distinctes d'un même cristal (e.g. surface / tranche / hauteur de tranche) mais également plusieurs cristaux ou encore plusieurs zones d'un wafer. De façon plus préférée, l'étape de capture peut être suivie d'une **étape 115 d'analyse** de l'image numérique capturée de façon à détecter au moins deux substrats ou couches de diamant en croissance. De façon encore plus préférée, l'étape de capture peut être suivie d'une **étape 115 d'analyse** de l'image numérique capturée de façon à détecter au moins deux couches de diamant en croissance. En effet, il est fréquent qu'un dépôt assisté par plasma microonde permette la croissance en parallèle de plusieurs couches de diamant simultanément. En outre, cette étape peut également comprendre une analyse de l'image numérisée de façon à extraire la géométrie du monocristal de diamant en croissance. La géométrie du monocristal de diamant en croissance permet si elle est analysée dans le temps de déduire les vitesses latérale et normale de croissance du diamant.

Une fois capturée, l'image numérique en couleur fait l'objet d'une **étape d'extraction 120** visant à récupérer des valeurs de caractéristiques de couleur. Les caractéristiques de couleur sont par exemple sélectionnées parmi le groupe consistant en : la teinte, la saturation, la luminosité, la brillance ou « valeur », ou les couleurs codées telles que rouge, vert, bleu (dans un référentiel RVB ou RGB en anglais) ou cyan, magenta, jaune, noir (dans un référentiel de quadrichromie). De préférence, les caractéristiques de couleur correspondent aux valeurs de codage rouge, vert, bleu (RVB).

La zone de l'image numérique capturée dont les valeurs de caractéristiques de couleur sont extraites peut être sélectionnée parmi plusieurs emplacements. Par exemple, ladite zone peut correspondre au support de substrat et plus particulièrement à la tranche ou à la surface du support de substrat ou encore ladite zone peut correspondre à un monocristal de diamant en croissance avec plus particulièrement le centre ou les côtés du diamant et cela à différentes hauteurs : bas, milieu, sub-surface ou surface de croissance. De façon préférée, la zone de l'image numérique capturée dont les valeurs de caractéristiques de couleur sont extraites est de préférence la tranche ou la surface du diamant. Dans le cadre de l'utilisation de la tranche, la couleur considérée est avantageusement la couleur de la sub-surface qui correspond par exemple à une position comprise entre 0,1 mm et 1 mm en dessous de la surface de croissance, de préférence 0,5 mm en dessous de la surface de croissance.

En outre, la dimension de la zone de l'image numérique capturée dont les valeurs de caractéristiques de couleur sont extraites peut correspondre à un pixel ou à plusieurs pixels. Dans le cas de plusieurs pixels, il est possible de calculer la moyenne ou la médiane des valeurs de caractéristiques de couleur.

Par ailleurs, le procédé de surveillance selon l'invention est destiné à être utilisé au cours d'un dépôt assisté par plasma microonde et la forme et les dimensions (e.g. hauteur) du monocristal en croissance évoluent au cours du procédé de dépôt. Ainsi, au cours du procédé de surveillance selon l'invention, la zone de l'image numérique capturée faisant l'objet de l'étape d'extraction 120 peut évoluer. C'est le cas lorsque cette zone correspond à la sub-surface dont la position évolue au cours du procédé de dépôt. Cela entraîne une modification de certaines des zones du diamant faisant l'objet d'une récupération des valeurs de caractéristiques de couleurs.

De façon avantageuse, l'étape d'extraction 120 peut être répétée à différents temps et/ou différents emplacements et peut être alors suivie d'une étape de détermination 122 d'une distribution des caractéristiques de couleur dans le temps et/ou dans l'espace. Dans ce cas, l'étape d'analyse 130 peut être réalisée à partir de la distribution des caractéristiques de couleur extraites dans le temps et/ou dans l'espace. De façon préférée, l'étape d'extraction 120 peut être répétée à différents temps et peut être alors suivie d'une étape de détermination 122 d'une distribution des caractéristiques de couleur dans le temps. Dans ce cas, l'étape d'analyse 130 peut être réalisée à partir de la distribution des caractéristiques de couleur extraites dans le temps.

De façon également avantageuse, l'étape d'extraction 120 peut être répétée pour différentes zones d'une même image numérique capturée et peut être alors suivie d'une étape de détermination 121 d'une distribution des caractéristiques de couleur, dans l'espace. Dans ce cas, l'étape d'analyse 130 peut être réalisée à partir de la distribution des caractéristiques de couleur extraites, dans l'espace.

Dans le cadre du dépôt assisté par plasma microonde, il est possible d'injecter dans la cavité résonante 21 un ou plusieurs gaz dits dopants comprenant des éléments tels que le bore, le soufre, le phosphore, le silicium, le lithium et le béryllium. Ainsi, le système d'arrivée des gaz 24 permet de mettre en œuvre un procédé où les gaz comprennent au moins un dopant à une concentration égale ou supérieure à 0,01 ppm. L'utilisation de tels gaz dits dopants permet de modifier les propriétés du diamant synthétisé. Cela peut par exemple modifier ses propriétés optiques et/ou électroniques. Ainsi, la croissance des couches de diamant peut se faire en présence d'un gaz dopé qui peut avoir une influence sur la couleur du diamant d'une part mais également plus largement sur la couleur du plasma à l'intérieur de la cavité résonante 21.

Ainsi, de façon avantageuse, lorsque le dépôt assisté par plasma microonde est réalisé en présence d'un gaz de traitement dopé, le procédé selon l'invention prend en compte l'influence dudit gaz de traitement dopé sur les caractéristiques de couleurs extraites lors de l'étape d'extraction 120. Il peut également prendre en compte l'influence de la couleur des couches de diamant obtenues avec ledit gaz de traitement dopé sur les caractéristiques de couleurs extraites durant l'étape d'extraction 120.

Bien que le procédé de surveillance de valeurs de paramètre selon l'invention puisse reposer exclusivement sur une ou plusieurs images numériques en couleur, ledit procédé peut comprendre en outre une étape de mesure de la densité d'hydrogène atomique, de la température du gaz, de la densité d'espèces carbonées ou de la température du diamant ou du substrat.

La mesure de température de gaz peut être réalisée à partir de mesures réalisées de façon continue. De façon préférée, elle est obtenue via des mesures de température rotationnelle de molécules ou radicaux C₂, CH, BH, H₂... à l'état excité par OES (Rayar, et al. Journal of Applied Physics, 104:3 ; 2008), (Rayar, et al. Journal of Physics D: Applied Physics, 39:10, 2151 ; 2006). Par exemple, dans le cas de C₂, elle peut être mesurée à partir de l'émission des bandes de Swan. La mesure de la température de la couche de diamant ou du substrat peut être réalisée par exemple par pyrométrie IR à deux longueurs d'onde sur sa tranche, sur sa surface de croissance ou sur le support de substrat.

La mesure de densité de H peut être réalisée de façon préférée par des techniques d'OES (d'actinométrie)(Gicquel et al. 1998), TALIF ou CRDS. Après calibration et pour le suivi d'un réacteur industriel, la méthode OES sera préférée bien qu'elle ne permette pas d'extraire des mesures absolues de densité d'espèces. Ainsi, pour l'atome d'hydrogène et les espèces carbonées, elle peut avantageusement contribuer au suivi du rapport de raies différentes (I_{H}/I_{Ar}, I_{CH}/I_{C2}...), témoins de l'activité du plasma, l'argon étant ajouté en impureté dans le plasma (A. Gicquel et al, Journal of Applied Physics, 1998).

De même, le procédé selon l'invention peut comprendre en outre une étape de mesure par spectroscopie de caractéristiques locales du plasma. Ces caractéristiques locales du plasma peuvent par exemple être le rapport de raies d'émission ou la température du gaz. En effet, dans une optique de contrôle fin des paramètres de croissance du réacteur de dépôt assisté par plasma microonde, il est très avantageux de coupler l'analyse des caractéristiques de couleur aux informations apportées par un pyromètre à deux longueurs d'onde et par la spectroscopie optique (e.g. de la spectroscopie d'émission). Cela permet notamment de déterminer le paramètre le plus pertinent sur lequel il faut agir (e.g. rapport Argon/Hydrogène du gaz de résistance thermique, débit des gaz, puissance, pression, pourcentage de méthane, type de dopant et sa teneur), débit d'hydrogène moléculaire et de méthane. Ainsi, avantageusement, le procédé selon l'invention peut comporter en outre une étape de mesure de valeurs d'intensité d'émission d'espèces du plasma par spectroscopie optique et de température par pyrométrie infrarouge à deux longueurs d'onde, lesdites valeurs étant analysées, par le module 13 de traitement de données, parallèlement aux valeurs de caractéristiques de couleur extraites, pour détecter une déviation des conditions de croissance lors du dépôt assisté par plasma microonde. Par parallèlement, il faut comprendre que cette analyse peut être conduite par le module 13 de traitement de données de préférence de façon simultanée. Néanmoins, cette analyse peut également être menée séquentiellement par exemple avec un faible écart de temps (de façon préférée < 1 minute).

Une fois les valeurs de caractéristiques de couleur extraites, le procédé selon l'invention comporte une **étape d'analyse 130** visant à analyser les valeurs de caractéristiques de couleur extraites pour détecter une déviation lors du dépôt assisté par plasma microonde. Avantageusement, les valeurs de caractéristiques de couleur doivent rester stables tout au long de l'expérience, exceptée dans le cas où intentionnellement les conditions de croissance seront modifiées ou modulées soit de façon périodique soit de façon permanente. La déviation est par exemple une déviation par rapport à une valeur de référence. Comme cela sera détaillé par la suite, la valeur de référence peut par exemple être une valeur mesurée préalablement lors de la même expérience ou une valeur obtenue lors d'une expérience précédente.

Le procédé selon l'invention peut également comporter une étape de comparaison des valeurs des caractéristiques de couleur déterminées aux valeurs des mêmes caractéristiques de couleur obtenues d'expériences de dépôt assisté par plasma microonde de référence. Cette étape de comparaison peut par exemple comprendre la comparaison de l'évolution temporelle des valeurs de la caractéristique de couleur à une évolution temporelle de référence des valeurs de la caractéristique de couleur. Ainsi, il y a une comparaison des cinétiques des valeurs des caractéristiques de couleurs.

Cette étape de comparaison peut être mise en œuvre au moyen du module de traitement de données 13 et elle peut être réalisée via des méthodes statistiques connues. De préférence, cette étape de comparaison peut être réalisée à partir de modèles de comparaisons, de classifications ou d'apprentissages tels que : réseau de neurone, Kernel, Multiple kernel learning, Support vector machine, arbres de décision, régression logistique, régression multiple, méthode des plus proches voisins et/ou forets aléatoire.

De façon plus préférée, l'étape de comparaison s'appuie sur un modèle, entraîné sur un jeu de données et configuré pour prédire les valeurs optimales des paramètres de dépôt assisté par plasma microonde. Plus particulièrement cette prédiction repose sur des jeux de données comportant des informations sur les valeurs des paramètres de dépôt, les valeurs des caractéristiques de couleurs, l'instant de mesure de ces valeurs et la qualité de la couche de diamant obtenue. Par exemple, aux fins de la calibration, il est possible d'utiliser un jeu de données provenant d'un ensemble d'expériences de dépôts assisté par plasma microonde, pour définir les valeurs des paramètres de dépôt, les valeurs des caractéristiques de couleurs, l'instant de mesure de ces valeurs et la qualité du diamant obtenu et par une étiquette par exemple binaire, de la forme « bonne qualité de diamant » / « mauvaise qualité de diamant ». Le jeu des données peut également comprendre des étiquettes multiples correspondant alors à des dimensions de diamants. De façon préférée, l'étape de comparaison 150 comporte l'utilisation d'un modèle d'apprentissage statistique supervisé.

L'invention peut également comporter une **étape de détermination 135** visant à déterminer des paramètres de dépôt assisté par plasma microonde à ajuster. Cette étape est réalisée à partir des valeurs de caractéristiques de couleur extraites. Avantageusement, elle peut en outre reposer sur des valeurs d'intensité d'émission d'espèces du plasma obtenues par exemple par spectroscopie optique, et de température, obtenue par exemple par pyrométrie IR à deux longueurs d'ondes.

De façon préférée, les paramètres de dépôt à contrôler au cours de la croissance de manière automatique (ou variables de procédé) sont sélectionnés parmi : le rapport des débits des gaz de résistance thermique (par exemple Argon / dihydrogène) et leur débit total, la pression, la puissance microonde injectée, le débit du précurseur carboné (e.g. méthane, éthane, diéthylène...), le rapport des débits des constituants du gaz de traitement (par exemple méthane / dihydrogène), le débit de gaz dopant. De façon plus préférée, les paramètres de dépôt sont sélectionnés parmi : le rapport des débits des gaz de résistance thermique et leur débit total, la pression, la puissance microonde injectée, le débit de précurseur carboné, le rapport des débits des constituants du gaz de traitement, et le débit de gaz dopant.

L'invention peut également comporter une **étape de détermination 136 visant à** calculer les nouvelles valeurs des paramètres de dépôt assisté par plasma microonde. L'étape de détermination 136 des nouvelles valeurs de paramètres de dépôt vise à déterminer les valeurs de paramètres de dépôt qui permettront d'obtenir des valeurs de caractéristiques de couleur permettant une croissance optimale. Avantageusement, les nouvelles valeurs de paramètres de dépôt sont déterminées de façon à ce que les valeurs de caractéristiques de couleur soient sensiblement identiques tout au long de l'expérience de dépôt. Cela peut être particulièrement adapté lorsque le procédé comprend une étape de comparaison réalisée à partir de modèles de comparaisons, de classifications ou d'apprentissages.

Le procédé selon l'invention peut en outre comporter une **étape 140 d'enregistrement** dans une mémoire des valeurs des caractéristiques de couleur déterminées associée à une indication temporelle de mesure et aux conditions de croissance. Cette étape d'enregistrement peut par exemple permettre la constitution d'une base de données comportant, pour une multitude d'expériences de dépôt assisté par plasma microonde, des informations sélectionnées parmi : les valeurs des paramètres de dépôt, les valeurs des caractéristiques de couleurs, l'instant de mesure de ces valeurs, la qualité du diamant obtenue et la référence de l'expérience de dépôt.

Le procédé selon l'invention peut en outre également comporter une **étape 150 de commande d'un réacteur 20 de dépôt** assisté par plasma microonde. L'étape 150 comporte par exemple la transmission des nouvelles valeurs de paramètre de dépôt générées par le module 13 de traitement de données à un module 15 de commande et la modification par le module 15 de commande des valeurs de paramètres de dépôt du réacteur 20.

**Selon un autre aspect, l**'invention porte sur un **dispositif 10 de surveillance d'un dépôt assisté par plasma microonde** pour la fabrication de diamant. Plus particulièrement, le dispositif 10 de surveillance selon l'invention comporte :
- un moyen 11 de capture d'image numérique,
- un module 12 de traitement d'image numérique, et
- un module 13 de traitement de données.

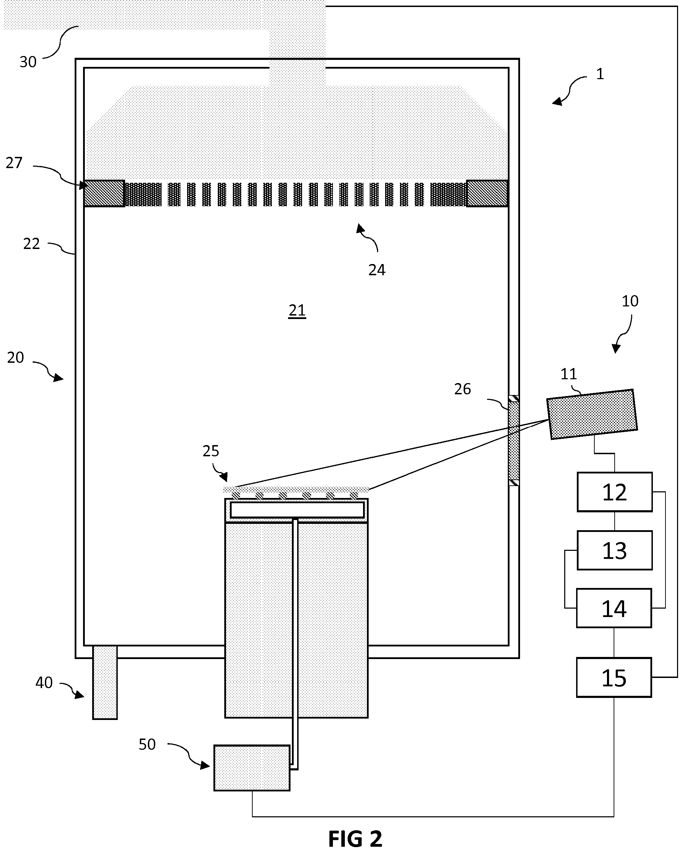

Un dispositif 10 de surveillance selon l'invention est représenté schématiquement sur la figure 2. Ces modules et moyens sont distincts sur la figure 2 mais l'invention peut prévoir divers type d'agencement comme par exemple un seul module cumulant l'ensemble des fonctions décrites ici. Ces modules peuvent être divisés en plusieurs cartes électroniques ou bien rassemblés sur une seule carte électronique. En outre, le dispositif 10 de surveillance selon l'invention peut comporter un moyen 14 de mémorisation.

Le moyen 11 de capture d'images numériques peut par exemple être une caméra numérique ou un appareil photo numérique. Il est configuré pour capturer une image numérique en couleur, ou une pluralité d'images numériques en couleur, d'au moins une couche de diamant en croissance. Ce moyen 11 de capture d'images numériques peut par exemple être une caméra numérique, un appareil photo numérique ou un capteur CCD (Charge Coupled Device). Ce dispositif peut être muni d'éléments optiques complémentaires tels que des objectifs, filtres neutres, filtres interférentiels, ou des filtres spectraux.

Le **module 12 de traitement d'image numérique** est configuré pour recevoir une image numérique capturée par le moyen 11, et extraire des valeurs de caractéristiques de couleur d'au moins une zone de l'image numérique capturée.

Le **module 13 de traitement de données** est configuré pour analyser les valeurs de caractéristiques de couleur extraites pour détecter une anomalie lors du dépôt assisté par plasma microonde. Il peut également être apte à déterminer de nouvelles valeurs de paramètres de dépôt assisté par plasma microonde à partir des valeurs de caractéristiques de couleur extraites.

Le module 12 de traitement d'image numérique et le module 13 de traitement de données comportent avantageusement un processeur et sont aptes à se connecter à un moyen 14 de mémorisation.

Le moyen 14 de mémorisation peut comprendre une mémoire transitoire et/ou une mémoire non transitoire. Il est apte à enregistrer, par exemple sous la forme de fichiers, la ou les images numériques en couleur. Il peut également être apte à enregistrer les valeurs des paramètres de dépôt. En outre, le dispositif 10 de surveillance selon l'invention peut comporter, ou être associé à, un serveur distant. Il est par exemple possible d'accéder à ce serveur distant via une interface web ou directement via les fonctions appropriées directement implémentées sur un dispositif de commande. Toutes les communications entre le ou les dispositif(s) de commande et le serveur distant peuvent être sécurisées par exemple par des protocoles HTTPS et chiffrement AES 512.

En outre, le dispositif 10 de surveillance selon l'invention peut comporter un module 15 de commande, configuré pour recevoir les nouvelles valeurs de paramètres de dépôt générées par le module 13 de traitement de données et apte à modifier les valeurs de paramètres de dépôt du réacteur 20 en fonction desdites nouvelles valeurs de paramètre de dépôt. Le module 15 de commande permet par exemple d'ajuster les paramètres de croissance en faisant varier les gaz de résistance thermique (par exemple composition et/ou débit).

En outre, le dispositif 10 de surveillance selon l'invention peut comporter un module de communication, configuré pour recevoir et transmettre des informations à des systèmes distants. Le module de communication permet de transmettre les données sur au moins un réseau de communication et peut comprendre une communication filaire ou sans fil. De préférence, la communication est opérée par l'intermédiaire d'un protocole sans fil tel que wifi, 3G, 4G, et/ou Bluetooth. Le module de communication permet par exemple d'envoyer sur un serveur distant une image numérique en couleur capturée ou des valeurs de caractéristiques de couleur d'au moins une zone de l'image numérique capturée. Il peut également être configuré pour envoyer les données relatives aux nouvelles valeurs de paramètres déterminées. Pour des raisons de sécurité, le module de communication peut être configuré pour seulement envoyer des informations sur les données relatives aux nouvelles valeurs de paramètres déterminés et non pour recevoir des instructions de contrôle des paramètres de dépôt assisté par plasma microonde.

Le procédé de surveillance d'un dépôt assisté par plasma microonde selon l'invention est de préférence mis en œuvre dans un réacteur de dépôt assisté par plasma microonde tel que schématisé sur la figure 2. Ainsi, **selon un autre aspect,** l'invention porte sur un **système 1 de dépôt assisté par plasma microonde** pour la fabrication de diamant comportant un réacteur 20 de dépôt assisté par plasma microonde couplé à un dispositif 10 de surveillance selon l'invention.

La Figure 2 schématise une vue en coupe d'un **réacteur 20 de dépôt** assisté par plasma microonde pour la croissance de diamant tel qu'il est possible d'en trouver dans la littérature. Le réacteur 20 de dépôt assisté par plasma microonde pour la fabrication de diamant peut comprendre :
- une **cavité résonante 21,** de préférence cylindrique et refroidie, formée au moins en partie, par les parois internes cylindriques d'une enceinte 22 du réacteur 20,
- un **système d'arrivée des gaz de traitement 24** apte à apporter des gaz de traitement au sein de la cavité résonante 21,
- un **générateur de microonde 30** configuré pour générer des microondes dont la fréquence est comprise entre 300 MHz et 3000 MHz,
- un **module de sortie des gaz 40** apte à retirer lesdits gaz de la cavité résonante 21,
- un **module de couplage des ondes 27** apte à transférer les microondes depuis le générateur de microonde jusqu'à la cavité résonante 21, de façon à permettre la formation d'un plasma,
- un **support de croissance 25** présent dans la cavité résonante 21,
- une **fenêtre d'observation 26,** et
- un **module d'injection de gaz de résistance thermique 50** apte à apporter des gaz de résistance thermique au sein de la cavité résonante 21 et en dessous du support de croissance 25.

Les réacteurs de dépôt assisté par microonde permettent la résonance d'une onde stationnaire créée au sein de la cavité résonante 21. Cette résonance est possible grâce à une sélection précise des dimensions de la cavité résonante 21 et elle permet la création d'ondes stationnaires du champ électrique. Ces réacteurs sont configurés pour permettre un champ électrique maximal au sein de la cavité résonante 21, de préférence légèrement au-dessus du support de croissance 25.

Le **générateur de microonde 30** est configuré pour générer des microondes dont la fréquence est comprise entre 300 MHz et 3000 MHz. Ces microondes sont essentielles à la création des ondes stationnaires de champ électrique au sein de la cavité. De préférence, le générateur de microonde 30 est configuré pour générer des microondes dont la fréquence est comprise entre 400 MHz et 2700 MHz. Par exemple, le générateur de microonde 30 peut générer des microondes dont la fréquence est comprise entre 2300 MHz et 2600 MHz ou entre 900 MHz et 1000 MHz ou entre 300 MHz et 500 MHz. De préférence, le générateur de microonde 30 peut générer des microondes dont la fréquence est sensiblement égale à 2450 MHz, 915 MHz ou 433 MHz. Il existe un grand nombre de générateurs pouvant être utilisés dans le cadre du réacteur 20. Le générateur utilisé peut par exemple être un générateur microonde apte à délivrer une puissance allant jusqu'à 6 kW et ceci à une fréquence sensiblement égale à 2450 MHz.

L'alimentation en microonde de la cavité 21, ou couplage, est réalisé par un **module de couplage des ondes 27** apte à transférer les microondes depuis le générateur de microonde 30 jusqu'à la cavité résonante 21 de façon à permettre la formation d'un plasma. Le module de couplage permet d'injecter, dans la cavité résonante 21, l'onde générée par le générateur de microonde 30 et pour cela il comporte un guide d'onde, une transition coaxiale et un coupleur microonde pour convoyer et guider les ondes électromagnétiques depuis le générateur d'ondes 30 jusqu'à la cavité résonante 21.

**L'enceinte 22 du réacteur 20** peut présenter différentes formes et dimensions. De préférence l'enceinte 22 est de forme cylindrique mais elle peut prendre d'autres formes. La hauteur de l'enceinte 22, telle que mesurée depuis la base de l'enceinte jusqu'à la surface interne du guide d'onde, peut être comprise par exemple entre 150 mm et 600 mm, de préférence 200 mm à 500 mm et de façon plus préférée entre 350 mm et 450 mm. Ces toutes dernières dimensions sont particulièrement préférées pour un fonctionnement à une fréquence micro-onde dans la plage de 900 MHz à 1000 MHz. Sauf si indiqué autrement, les dimensions préférées ou les conditions de croissance pour un réacteur 20 opérant à des fréquences comprises entre 300 MHz et 500 MHz pourront être obtenues en multipliant les dimensions adaptées à un réacteur opérant à des fréquences comprises entre 900 MHz et 1000 MHz, par un facteur compris entre 3,4 et 1,8. Sauf si indiqué autrement, les dimensions préférées ou les conditions de croissance pour un réacteur 20 opérant à des fréquences comprises entre 2300 MHz et 2600 MHz pourront être obtenues en divisant les dimensions adaptées à un réacteur 20 opérant à des fréquences comprises entre 900 MHz et 1000 MHz, par un facteur compris entre 2,3 et 2,9. L'enceinte 20 selon l'invention est généralement constituée de métal, de préférence constituée d'aluminium ou d'un alliage d'aluminium. L'alliage d'aluminium comprend de préférence au moins 80%, de façon plus préférée au moins 90%, et de façon encore plus préférée au moins 98% en poids d'aluminium.

La **cavité résonante 21** est formée, au moins en partie, par les parois internes cylindriques de l'enceinte 22 du réacteur 20. La cavité résonante 21 est par exemple formée pour sa partie inférieure par la base de l'enceinte 20. La cavité résonante 21 est de préférence cylindrique. La cavité résonante 21 possède un axe de symétrie partant du plan de la base de l'enceinte jusqu'au plan d'une surface de la fenêtre diélectrique d'injection des ondes et est de préférence adaptée à un mode de résonance de micro-ondes de type TM. La base de l'enceinte peut présenter un diamètre différent du diamètre de la cavité résonante 21.

Le réacteur 20 comme présenté sur la figure 2 comprend également un **support de croissance 25** situé dans la cavité résonante 21. Ce support de croissance 25 peut, par exemple, former une grande surface plane, sur laquelle le ou les substrats sont destinés à être positionnés. Ce support de croissance 25 peut comprendre des saillies, des cercles, des trous ou des rainures, permettant d'aligner et de maintenir le ou les substrat(s). En variante, le support de croissance 25 comporte une surface de support plane sur laquelle le ou les substrats sont disposés.

Le réacteur de dépôt assisté par plasma microonde comprend **un système d'arrivée de gaz de traitement 30** apte à apporter des gaz de traitement au sein de la cavité résonante 21. Ce système d'arrivée de gaz de traitement 30 permet de mettre en œuvre un procédé où les gaz de traitement sont injectés vers la surface de croissance à un débit total de gaz d'au moins 100 cm³ par minute. Les gaz de traitement apportés au sein de la cavité résonante 21 comprennent au moins une source de carbone et une source d'hydrogène moléculaire. La source de carbone est de préférence du méthane (mais également de l'acétylène, de l'éthane ou tout autres sources de carbone). Par exemple, pour un réacteur 20 opérant à des fréquences comprises entre 900 MHz et 1000 MHz, le débit de gaz est de préférence d'au moins 750 cm³ par minute, de façon plus préférée d'au moins 1000 cm³ par minute. Au sein de la cavité résonante 21, ces gaz sont activés par les microondes pour former un plasma dans les régions de champ électrique élevé. Des radicaux contenant du carbone réactif peuvent ensuite diffuser à partir du plasma pour se déposer sur le ou les substrats et ainsi permettre la croissance du diamant. Le système d'arrivée de gaz de traitement 30 peut également permettre l'injection dans la cavité résonante 21 d'un ou plusieurs gaz dits dopants comprenant des éléments tels que le bore, le soufre, le phosphore, le silicium, le lithium et le béryllium, autre. Ainsi, le système d'arrivée de gaz de traitement 30 permet de mettre en œuvre un procédé où les gaz comprennent au moins un dopant à une concentration égale ou supérieure à 0,01 ppm.

Le **module de sortie des gaz 40** permet d'évacuer les gaz présents dans la cavité résonante 21. Il comprend une ou plusieurs sorties de gaz, situées de préférence dans la partie inférieure du réacteur de dépôt. Une ou plusieurs sorties de gaz peuvent être situées autour du et sous le support de croissance 25.

Compte tenu de la température du gaz atteinte dans le cœur du plasma (e.g. plus de 2500K et jusqu'à 5000K), un refroidissement extrêmement efficace des parois du réacteur 20 est nécessaire. La température de gaz du plasma se répercute sur les parois 22 qui sont soumises à un flux de chaleur important. Pour pallier cela un système de refroidissement des parois est généralement mis en œuvre.

En outre, le procédé de surveillance selon l'invention, est de préférence mis en œuvre dans le cadre d'un procédé de synthèse de diamant par dépôt assisté par plasma microonde. Ainsi, **selon un autre aspect,** l'invention porte sur un **procédé 200 de synthèse de diamant par dépôt assisté par plasma microonde,** ledit procédé 200 de synthèse comprenant une étape de surveillance correspondant au procédé de surveillance selon l'invention.

Le procédé 200 de synthèse selon l'invention comprend en outre une **étape 210 consistant à placer le ou les substrats sur le support de croissance 25 du réacteur 20.** Par exemple, il est possible d'utiliser une plaque de silicium, une plaque de métal (Mo, W, autre, ...) une plaque de diamant polycristallin, des monocristaux de diamant (naturels, issus d'un procédé haute pression-haute température (HPHT), issus d'un procédé CVD (chemical vapor deposition) utilisant l'invention du réacteur modulaire ou non, ou bien encore des monocristaux d'autres matériaux (métaux ou autre ..). La synthèse du diamant s'effectue de préférence sur des substrats de diamant monocristallin. Ainsi, le procédé de synthèse de diamant selon l'invention comporte de préférence une croissance homoépitaxique. Les substrats de diamant monocristallin peuvent présenter différentes formes et dimensions. Par exemple, ils peuvent présenter une forme de cylindre, de cube, de parallélépipède, ou autre. Les dimensions peuvent par exemple varier de 100 micromètres à plusieurs millimètres de hauteur et de plusieurs millimètres, voire centimètres, de diamètre ou de côtés.

Le procédé de synthèse 200 selon l'invention comporte une **étape 220 de mise en fonctionnement du réacteur 20.** Cette étape a pour objectif :
- de générer une pression comprise entre 0,2 hPa et 500 hPa au sein de la cavité résonante 21,
- d'injecter des microondes, de préférence en mode de transmission TM₀₁₁, et à une puissance comprise par exemple entre 1 kW et 100 kW (ou plus), selon le type de générateur utilisé (fréquence utilisée),
- d'injecter des gaz, par exemple à un débit total d'au moins 500 cm³ par minute, les gaz comprenant par exemple du méthane et du dihydrogène, et des additifs tels que oxygène, azote, bore, phosphore et argon, et
- de mettre en fonctionnement les systèmes de refroidissement de l'enceinte avec son système de gaz de résistance thermique ainsi qu'un système de contrôle de refroidissement du substrat pour contrôler la température de la ou des surfaces de croissance, du système d'injection des gaz et du porte substrat.

Pour un réacteur fonctionnant à la fréquence de 915 MHz, cela permet par exemple de délivrer sur la surface de croissance du substrat une densité de puissance surfacique d'au moins 0,5 W/mm², de préférence au moins 2 W/mm² et de façon encore plus préférée au moins 3 W/mm² de la surface de croissance du substrat. Généralement la densité de puissance est inférieure à 5 W/mm² à la surface de croissance du substrat. Cette étape permet de générer un plasma au-dessus de la surface de croissance du substrat et de permettre d'initier la croissance cristalline. En outre, la température du substrat est maintenue constante grâce aux systèmes de refroidissement à une température comprise par exemple entre 700°C et 1400°C., sauf dans le cas de croissance de diamant nano ou ultra-nanocristallin. Une description des différentes conditions de croissance peut être trouvée dans des ouvrages de référence (Derjaguin B. V., Journal of Crystal growth 31 (1975) 44-48 ; C. Wild et al, Diamond and Related Materials, 2 (1993) 158-168 ; Gicquel A et al. Current Applied Physics, vol1 Issue 6 , (2001) 479 ; Achard J et al, Journal of Crystal Growth 284 (2005) 396-405 ; Butler et al, J of physics-condensed Matter, vol 21, Issue 36 (2009) ; Silva et al, phys. stat. sol. (a) 203, No. 12, (2006) 3049-3055 ; Widman C, J et al Diamond & Related Materials 64 (2016) 1-7). La densité de puissance surfacique peut en outre être variée brutalement, par exemple par une variation de pression, pour assurer des variations brusques de composition ou de température de croissance (Tallaire et al., Diamond & Related Materials 51, 55-60, 2015) du ou des substrats par exemple.

Le procédé de synthèse 200 selon l'invention comporte une **étape 230 de croissance (épaississement/élargissement) du film de diamant.** Pour des films polycristallins, cette étape intervient après la coalescence des cristaux et la formation d'un film cristallin. Elle a pour objectif l'épaississement du film cristallin et l'amélioration de sa qualité cristalline. Pour des monocristaux, l'élargissement permet l'obtention de surface de croissance plus grande que le substrat de départ et après une croissance normale de couches de diamant de grandes dimensions.

### Exemples

Ces exemples montrent un suivi de l'évolution de la température d'un diamant pendant la croissance via l'étude de la variation de sa couleur (quantifiée via les valeurs de codage RVB).

Le suivi des valeurs RVB au cours de la synthèse est réalisé par le traitement des images prises automatiquement par une caméra, de type Grasshopper 3, à intervalle de temps régulier. Ce traitement des images est effectué par une suite de traitements automatiques dans lesquels pour chaque image, les valeurs RVB d'un (ou plusieurs) pixel choisi sont lues et sauvegardées dans un fichier. Les valeurs RVB de ce pixel - donc d'une zone précise du diamant- sont ensuite représentées graphiquement en fonction du temps de synthèse.

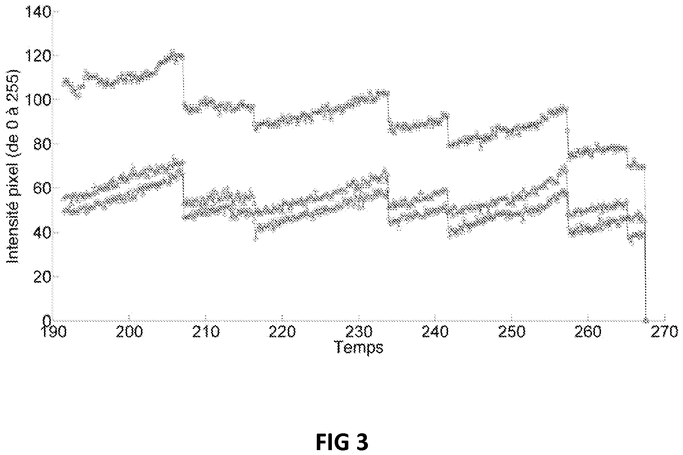

Dans le cas de la croissance présentée pour cet exemple, quatre zones sont suivies : la surface du diamant, le centre du diamant à mi-hauteur, le centre du diamant à sa base et le diamant polycristallin poussant sur le porte-substrat. La Figure 3 montre un exemple de suivi des valeurs de codage R (rouge) pour chaque zone en fonction du temps. Les chutes brutales des courbes correspondent à des changements des paramètres de croissance.

Ainsi, il est possible d'observer sur cette figure 3, et plus particulièrement sur la courbe correspondant à la tranche du diamant (centre -triangles), que le suivi des valeurs de caractéristiques de couleurs permet la surveillance du dépôt assisté par plasma microonde au sein du réacteur.

Il est possible avec cette solution d'enregistrer en temps réel les valeurs RVB pour avoir un contrôle en continu et permettre une régulation des paramètres de croissance.

Le module 15 de commande agissant sur les paramètres de croissance et notamment sur les gaz de résistance thermique permet de conserver sensiblement identique les valeurs de caractéristiques de couleurs (e.g. RVB) pendant une longue période de croissance. Une période de croissance peut par exemple s'étendre de quelques jours à quelques semaines.

## Revendications

1. Procédé (100) de surveillance des conditions de croissance d'un dépôt assisté par plasma microonde pour la fabrication de diamant, ledit procédé étant mis en œuvre par un dispositif (10) de surveillance comprenant au moins un moyen (11) de capture d'image numérique, un module (12) de traitement d'image numérique, et un module (13) de traitement de données, ledit procédé comportant les étapes :
- de capture (110) d'une image numérique en couleur d'au moins une couche de diamant en croissance, à l'aide du moyen (11) de capture d'image numérique,
- d'extraction (120) de valeurs de caractéristiques de couleur d'au moins une zone de l'image numérique capturée, par le module (12) de traitement d'image numérique, lesdites caractéristiques de couleur correspondant à la couleur de l'au moins une couche de diamant en croissance et étant sélectionnées parmi le groupe consistant en : la teinte, la saturation, la luminosité, la brillance, et les couleurs codées dans un référentiel de quadrichromie ou Rouge-Vert-Bleu, et
- d'analyse (130), par le module (13) de traitement de données, des valeurs de caractéristiques de couleur extraites pour détecter une déviation des conditions de croissance lors du dépôt assisté par plasma microonde,
ledit procédé comprenant en outre une étape (136) de détermination de nouvelles valeurs de paramètres de dépôt assisté par plasma microonde et une étape (150) de commande incluant la transmission des nouvelles valeurs de paramètres de dépôt, déterminées par le module (13) de traitement de données, à un module (15) de commande et une modification, par le module (15) de commande, des valeurs de paramètres de dépôt assisté par plasma.

2. Procédé selon la revendication 1 **caractérisé en ce que** l'étape d'extraction (120) est répétée à différents temps et/ou différents emplacements et est suivie d'une étape de détermination (122) d'une distribution des caractéristiques de couleur dans le temps et/ou dans l'espace, et **en ce que** l'étape d'analyse (130) est réalisée à partir de la distribution des caractéristiques de couleur extraites, dans le temps et/ou dans l'espace.

3. Procédé selon l'une des revendications 1 ou 2, **caractérisé en ce qu'**il comporte en outre une étape de mesure de valeurs d'intensité d'émission d'espèces du plasma par spectroscopie optique et de température par pyrométrie infrarouge à deux longueurs d'onde, lesdites valeurs étant analysées, par le module (13) de traitement de données, parallèlement aux valeurs de caractéristiques de couleur extraites, pour détecter une déviation des conditions de croissance lors du dépôt assisté par plasma microonde.

4. Procédé selon l'une quelconque des revendications 1 à 3, **caractérisé en ce qu'**il comprend en outre une étape (135) de détermination des paramètres de dépôt assisté par plasma microonde à ajuster.

5. Procédé selon l'une quelconque des revendications 1 à 4, **caractérisée en ce qu'**il comporte une étape (140) d'enregistrement dans une mémoire de la caractéristique de couleur extraite associée à une indication temporelle de mesure et aux conditions de croissance.

6. Procédé selon l'une quelconque des revendications 1 à 5, **caractérisée** en qu'il comporte une étape de comparaison des valeurs des caractéristiques de couleur extraites à des valeurs des mêmes caractéristiques de couleur obtenues d'expériences de dépôt assisté par plasma microonde de références, ladite étape de comparaison s'appuyant sur un modèle entraîné sur un jeu de données de référence et configuré pour prédire des valeurs optimales des paramètres de dépôt assisté par plasma microonde.

7. Procédé selon l'une quelconque des revendications 1 à 6, **caractérisée en ce qu'**il comporte une étape de constitution d'une base de données comportant, pour une multitude d'expériences de dépôt assisté par plasma microonde, des informations sélectionnées parmi : des valeurs des paramètres de dépôt, des valeurs de caractéristiques de couleurs, un instant de mesure de ces valeurs, une qualité de diamant obtenue et une référence de l'expérience de dépôt.

8. Procédé selon les revendications 6 et 7, **caractérisée en ce que** la prédiction des valeurs optimales des paramètres de dépôt assisté par plasma microonde repose sur des jeux de données comportant des informations sur les valeurs des paramètres de dépôt, les valeurs des caractéristiques de couleurs, l'instant de mesure de ces valeurs et la qualité de diamant obtenue.

9. Procédé selon l'une quelconque des revendications 1 à 8, **caractérisé en ce que** l'au moins une zone de l'image numérique capturée dont les valeurs de caractéristiques de couleur sont extraites est la tranche ou la surface du diamant.

10. Procédé selon la revendication 9, **caractérisé en ce que** les valeurs de caractéristiques de couleur sont extraites de la tranche et **en ce que** la couleur considérée est la couleur de la sub-surface, ladite sub-surface correspondant à une position comprise entre 0,1 mm et 1 mm en dessous d'une surface de croissance.

11. Dispositif (10) de surveillance des conditions de croissance d'un dépôt assisté par plasma microonde pour la fabrication de diamant, apte à mettre en œuvre le procédé de surveillance selon l'une des revendications 1 à 10, ledit dispositif comportant :
- un moyen (11) de capture d'image numérique, apte à capturer une image numérique en couleur d'au moins un diamant en croissance,
- un module (12) de traitement d'image numérique, apte à extraire des valeurs de caractéristiques de couleur d'au moins une zone de l'image numérique capturée, lesdites caractéristiques de couleur correspondant à la couleur de l'au moins une couche de diamant en croissance et étant sélectionnées parmi le groupe consistant en : la teinte, la saturation, la luminosité, la brillance, et les couleurs codées dans un référentiel de quadrichromie ou Rouge-Vert-Bleu, et
- un module (13) de traitement de données, configuré pour :
∘ détecter une déviation des conditions de croissance lors du dépôt assisté par plasma microonde à partir des valeurs de caractéristiques de couleur extraites,
∘ déterminer de nouvelles valeurs de paramètres de dépôt assisté par plasma microonde à partir des valeurs de caractéristiques de couleur extraites,
ledit dispositif de surveillance étant configuré pour transmettre les nouvelles valeurs de paramètre de dépôt à un module (15) de commande apte à modifier des valeurs de paramètres de dépôt assisté par plasma en fonction desdites nouvelles valeurs de paramètre de dépôt.

12. Système (1) contrôle-commande de dépôt assisté par plasma microonde pour la fabrication de diamant comportant un réacteur (20) de dépôt assisté par plasma microonde **caractérisé en ce qu'**il comprend en outre :
- un dispositif (10) de surveillance d'un dépôt assisté par plasma microonde selon la revendication 11, et
- un module (15) de commande, configuré pour recevoir les nouvelles valeurs de paramètres de dépôt générées par le module (13) de traitement de données du dispositif (10) de surveillance et apte à modifier les valeurs de paramètres de dépôt du réacteur (20) en fonction desdites nouvelles valeurs de paramètre de dépôt.

13. Système (1) contrôle-commande de dépôt assisté par plasma microonde selon la revendication 12 **caractérisé en ce qu'**il comprend en outre un pyromètre à deux longueurs d'onde et un dispositif de spectroscopie d'émission.

## Patentansprüche

1. Verfahren (100) zum Überwachen der Wachstumsbedingungen einer mikrowellenplasmaunterstützten Abscheidung für die Diamantherstellung, wobei das Verfahren durch eine Überwachungsvorrichtung (10) durchgeführt wird, die mindestens ein digitales Bilderfassungsmittel (11), ein digitales Bildverarbeitungsmodul (12) und ein Datenverarbeitungsmodul (13) umfasst, wobei das Verfahren die folgenden Schritte umfasst:
- Erfassen (110) eines digitalen Farbbildes von mindestens einer wachsenden Diamantschicht unter Verwendung der digitalen Bilderfassungsmittel (11),
- Extrahieren (120) von Farbmerkmalswerten aus mindestens einem Bereich des erfassten digitalen Bildes durch das digitale Bildverarbeitungsmodul (12), wobei die Farbmerkmale der mindestens einen wachsenden Diamantschicht entsprechen und ausgewählt sind aus der Gruppe bestehend aus Farbton, Sättigung, Leuchtkraft, Brillianz und den Farben, die in einem Vierfarb- oder Rot-Grün-Blau-Bezugsrahmen codiert sind, und
- Analysieren (130) der extrahierten Farbmerkmalswerte durch das Datenverarbeitungsmodul (13), um Abweichungen von den Wachstumsbedingungen während der mikrowellenplasmagestützten Abscheidung zu erkennen,
wobei das Verfahren ferner einen Schritt (136) des Bestimmens neuer Mikrowellenplasmaabscheidungsparameterwerte und einen Steuerungsschritt (150) umfasst, der die Übertragung der neuen, durch das Datenverarbeitungsmodul (13) bestimmten Abscheidungsparameterwerte an ein Steuerungsmodul (15) und eine Modifikation der Plasmaabscheidungsparameterwerte durch das Steuerungsmodul (15) einschließt.

2. Verfahren nach Anspruch 1, **dadurch gekennzeichnet, dass** der Extraktionsschritt (120) zu verschiedenen Zeiten und/oder an verschiedenen Orten wiederholt wird und sich ein Schritt des Bestimmens (122) einer zeitlichen und/oder räumlichen Verteilung der Farbmerkmale anschließt, und dass der Analyseschritt (130) auf der Grundlage der zeitlichen und/oder räumlichen Verteilung der extrahierten Farbmerkmale durchgeführt wird.

3. Verfahren nach einem der Ansprüche 1 oder 2, **dadurch gekennzeichnet, dass** es ferner einen Schritt der Messung von Werten der Emissionsintensität von Spezies aus dem Plasma durch optische Spektroskopie und der Temperatur durch Doppelwellenlängen-Infrarotpyrometrie umfasst, wobei die Werte durch das Datenverarbeitungsmodul (13) parallel zu den extrahierten Farbmerkmalswerten analysiert werden, um eine Abweichung von den Wachstumsbedingungen während der mikrowellenplasmaunterstützten Abscheidung zu erkennen.

4. Verfahren nach einem der Ansprüche 1 bis 3, **dadurch gekennzeichnet, dass** es ferner einen Schritt (135) des Bestimmens der einzustellenden Parameter für die mikrowellenplasmaunterstützte Abscheidung umfasst.

5. Verfahren nach einem der Ansprüche 1 bis 4, **dadurch gekennzeichnet, dass** es einen Schritt (140) der Aufzeichnung des extrahierten Farbmerkmals, das mit einer Messzeitangabe und den Wachstumsbedingungen verbunden ist, in einem Speicher umfasst.

6. Verfahren nach einem der Ansprüche 1 bis 5, **dadurch gekennzeichnet, dass** es einen Schritt des Vergleichens der Werte der extrahierten Farbmerkmale mit Werten derselben Farbmerkmale umfasst, die aus Referenzversuchen zur Mikrowellenplasmaabscheidung erhalten wurden, wobei der Vergleichsschritt auf einem Modell beruht, das auf einem Referenzdatensatz trainiert wurde und so konfiguriert ist, dass es optimale Werte der Mikrowellenplasmaabscheidungsparameter vorhersagt.

7. Verfahren nach einem der Ansprüche 1 bis 6, **dadurch gekennzeichnet, dass** es einen Schritt des Aufbauens einer Datenbank umfasst, die für eine Vielzahl von mikrowellenplasmaunterstützten Abscheidungsexperimenten Informationen enthält, die ausgewählt sind aus: Abscheidungsparameterwerten, Farbmerkmalswerten, einem Zeitpunkt der Messung dieser Werte, einer erhaltenen Diamantqualität und einer Referenz des Abscheidungsexperiments.

8. Verfahren nach den Ansprüchen 6 und 7, **dadurch gekennzeichnet, dass** die Vorhersage der optimalen Werte der mikrowellenplasmaunterstützten Abscheidungsparameter auf Datensätzen basiert, die Informationen über die Abscheidungsparameterwerte, die Farbmerkmalswerte, den Zeitpunkt der Messung dieser Werte und die erhaltene Diamantqualität umfassen.

9. Verfahren nach einem der Ansprüche 1 bis 8, **dadurch gekennzeichnet, dass** der mindestens eine Bereich des erfassten digitalen Bildes, aus dem Farbmerkmalswerte extrahiert werden, die Kante oder Oberfläche des Diamanten ist.

10. Verfahren nach Anspruch 9, **dadurch gekennzeichnet, dass** die Farbmerkmalswerte aus dem Wafer extrahiert werden und dass die betrachtete Farbe die Farbe der Unterfläche ist, wobei die Unterfläche einer Position zwischen 0,1 mm und 1 mm unterhalb einer Wachstumsoberfläche entspricht.

11. Vorrichtung (10) zur Überwachung der Wachstumsbedingungen einer mikrowellenplasmaunterstützten Abscheidung zur Herstellung von Diamanten, geeignet zur Durchführung des Überwachungsverfahrens nach einem der Ansprüche 1 bis 10, wobei die Vorrichtung umfasst:
- ein digitales Bilderfassungsmittel (11), das geeignet ist, ein digitales Farbbild von mindestens einem wachsenden Diamanten aufzunehmen,
- ein digitales Bildverarbeitungsmodul (12), das in der Lage ist, Farbmerkmalswerte aus mindestens einem Bereich des aufgenommenen digitalen Bildes zu extrahieren, wobei die Farbmerkmale der Farbe der mindestens einen wachsenden Diamantschicht entsprechen und ausgewählt sind aus der Gruppe bestehend aus: Farbton, Sättigung, Leuchtkraft, Brillianz und in einem Vierfarb- oder Rot-Grün-Blau-Bezugsrahmen codierte Farben, und
- ein Datenverarbeitungsmodul (13), das konfiguriert ist zum:
o Erkennen von Abweichungen von den Wachstumsbedingungen während der Mikrowellenplasmabeschichtung anhand der extrahierten Farbmerkmalswerte,
o Bestimmen neuer Parameterwerte für die Mikrowellenplasmaabscheidung aus den extrahierten Farbmerkmalswerten,
wobei die Überwachungsvorrichtung so konfiguriert ist, dass sie die neuen Abscheidungsparameterwerte an ein Steuerungsmodul (15) übermittelt, das in der Lage ist, die Parameterwerte für die plasmaunterstützte Abscheidung entsprechend den neuen Abscheidungsparameterwerten zu ändern.

12. Mikrowellenplasmaunterstütztes Abscheidungssteuerungssystem (1) für die Herstellung von Diamanten, das einen mikrowellenplasmaunterstützten Abscheidungsreaktor (20) umfasst, **dadurch gekennzeichnet, dass** es ferner umfasst:
- eine Vorrichtung (10) zur Überwachung einer Mikrowellenplasmaabscheidung nach Anspruch 11, und
- ein Steuerungsmodul (15), das so konfiguriert ist, dass es die neuen Abscheidungsparameterwerte empfängt, die vom Datenverarbeitungsmodul (13) der Überwachungsvorrichtung (10) erzeugt werden, und so angepasst ist, dass es die Abscheidungsparameterwerte des Reaktors (20) entsprechend den neuen Abscheidungsparameterwerten ändert.

13. Mikrowellenplasmaunterstütztes Abscheidungsüberwachungs- und -steuerungssystem (1) nach Anspruch 12, **dadurch gekennzeichnet, dass** es außerdem ein Doppelwellenlängen-Pyrometer und eine Emissionsspektroskopievorrichtung umfasst.

## Claims

1. A method (100) for monitoring the growth conditions of a microwave plasma-assisted deposition for diamond manufacture, said method being implemented by a monitoring device (10) comprising at least one digital image capture means (11), one digital image processing module (12), and one data processing module (13), said method including the steps of:
- capturing (110) a digital color image of at least one growing diamond layer, using the digital image capturing means (11),
- extracting (120) color characteristic values from at least one area of the captured digital image, by the digital image processing module (12), said color characteristics corresponding to the color of the at least one growing diamond layer and being selected from the group consisting of: hue, saturation, brightness, brilliance, and the colors encoded in a four-color or Red-Green-Blue repository, and
- analyzing (130), by the data processing module (13), the extracted color characteristic values to detect a deviation of the growth conditions during the microwave plasma-assisted deposition,
said method further comprising a step (136) of determining new values of microwave-assisted plasma deposition parameters and a control step (150) including transmitting the new deposition parameter values, determined by the data processing module (13), to a control module (15) and modifying, by the control module (15), the plasma assisted-deposition parameter values.

2. The method according to claim 1, **characterized in that** the extraction step (120) is repeated at different times and/or locations and is followed by a step of determining (122) a distribution of color characteristics in time and/or space, and **in that** the analysis step (130) is performed from the distribution of the extracted color characteristics in time and/or space.

3. The method according to one of claims 1 or 2, **characterized in that** it further includes a step of measuring values of emission intensity values of plasma species by optical spectroscopy and temperature by two-wavelength infrared pyrometry, said values being analyzed, by the data processing module (13), in parallel with the extracted color characteristic values, to detect a deviation of the growth conditions during the microwave plasma-assisted deposition.

4. The method according to any one of claims 1 to 3, **characterized in that** it further comprises a step (135) of determining the microwave plasma-assisted deposition parameters to be adjusted.

5. The method according to any one of claims 1 to 4, **characterized in that** it includes a step (140) of storing in a memory the extracted color characteristic associated with a measurement time indication and the growth conditions.

6. The method according to any one of claims 1 to 5, **characterized in that** it comprises a step of comparing the values of the color characteristics extracted with the values of the same color characteristics obtained from reference microwave plasma-assisted deposition experiments, said comparison step relying on a model trained on a reference dataset and configured to predict optimal values of the microwave plasma-assisted deposition parameters.

7. The method according to any one of claims 1 to 6, **characterized in that** it comprises a step of constituting a database containing, for a multitude of microwave plasma-assisted deposition experiments, information selected from: values of deposition parameters, values of color characteristics, a measurement time of these values, a quality of the diamond obtained, and a reference of the deposition experiment.

8. The method according to claims 6 and 7, **characterized in that** the prediction of the optimal values of the microwave plasma-assisted deposition parameters is based on datasets containing information on the values of the deposition parameters, the values of the color characteristics, the time of measurement of these values, and the quality of the diamond layer obtained.

9. The method according to any one of claims 1 to 8, **characterized in that** the at least one area of the captured digital image from which the color characteristic values are extracted is the edge or the surface of the diamond.

10. The method according to claim 9, **characterized in that** the color characteristic values are extracted from the edge and **in that** the color considered is the color of the subsurface, said subsurface corresponding to a position between 0.1 mm and 1 mm below the growing surface.

11. A device (10) for monitoring the growth conditions of a microwave plasma-assisted deposition for diamond manufacture, capable of implementing the monitoring method according to one of claims 1 to 10, said device including:
- a digital image capture means (11), capable of capturing a digital color image of at least one growing diamond,
- a digital image processing module (12), capable of extracting color characteristic values from at least one area of the captured digital image, said color characteristics corresponding to the color of the at least one growing diamond layer and being selected from the group consisting of: hue, saturation, brightness, brilliance, and the colors encoded in a four-color or Red-Green-Blue repository, and
- a data processing module (13), configured to:
∘ detect a deviation of the growth conditions during the microwave plasma-assisted deposition from the extracted color characteristic values,
∘ determine new values of microwave plasma-assisted deposition parameters from the extracted color characteristic values,
said monitoring device being configured to transmit the new values of microwave plasma-assisted deposition parameters to a control module (15) capable of modifying the reactor deposition parameter values depending on said new deposition parameter values.

12. A microwave plasma-assisted deposition control-command system (1) for diamond manufacture including a microwave plasma-assisted deposition reactor (20) **characterized in that** it further comprises:
- a device (10) for monitoring a microwave plasma-assisted deposition according to claim 11, and
- a control module (15), configured to receive the new deposition parameter values generated by the data processing module (13) of the monitoring device (10) and capable of modifying the reactor deposition parameter values (20) depending on said new deposition parameter values.

13. The microwave plasma-assisted deposition control-command system (1) according to claim 12, **characterized in that** it further comprises a two-wavelength pyrometer and an emission spectroscopy device.
